# EUROPÄISCHE PATENTSCHRIFT

(11) **EP 1 791 192 B1**
(45) Veröffentlichungstag und Bekanntmachung des Hinweises auf die Patenterteilung: **12.03.2008**
(21) Anmeldenummer: 05025738.5
(22) Anmeldetag: 25.11.2005
(51) Int. Cl.: H01L 41/09

(54) **Piezo-Biegewandler**
Piezoelectric bender transducer
Transducteur piézo-électrique à flexion

(43) Veröffentlichungstag der Anmeldung: 30.05.2007
(73) Patentinhaber: Festo AG & Co., 73734 Esslingen (DE)
(72) Erfinder: Weinmann, Michael, Dr.-Ing., 73655 Plüderhausen (DE); Schmid, Andreas Joseph, Dr.-Ing., 96450 Coburg (DE); Fuss, Martin, Dipl.-Ing., 73760 Ostfilden/Ruit (DE); Schaepperle, Jochen, Dipl.-Ing., 70180 Stuttgart (DE)
(74) Vertreter: Abel, Martin

(56) Entgegenhaltungen:
- WO-A-01/75987
- WO-A-01/99205
- DE-U1-6202005 006 12
- US-A- 4 349 762

## Beschreibung

Die Erfindung betrifft einen Piezo-Biegewandler, mit mindestens einem streifen- oder plattenförmigen Biegewandlerelement, das einen einseitig mit einem piezoelektrischen Körper belegten, piezoelektrisch inaktiven mehrschichtigen Basiskörper aufweist.

Ein aus der DE 20 2005 006 126 U bekannter Piezo-Biegewandler dieser Art enthält ein Biegewandlerelement, das einen in sich die Funktionen eines Tragkörpers und eines thermischen Anpasskörpers vereinigenden Basiskörper aufweist, der einseitig mit einem piezoelektrischen Körper belegt ist. Der Basiskörper ist insgesamt so strukturiert, dass er im Wesentlichen das gleiche thermische Ausdehnungsverhalten wie der einseitig daran angebrachte piezoelektrische Körper aufweist. Auf diese Weise soll eine thermische Neutralisierung des Temperaturverhaltens des einseitig aufgebrachten piezoelektrischen Körpers erzielt werden.

Aus der DE 692 18 553 T2 ist ein piezoelektrisch betätigtes Durchfluss-Regelventil bekannt, bei dem das Ventilglied als Piezo-Biegwandler ausgebildet ist. Dieser besteht aus einem als Substrat bezeichneten Basiskörper aus Metall oder sonstigem nicht-keramischem Material, der einseitig oder beidseitig mit einem piezoelektrischen Körper belegt ist. Die Dicken des Substrates und der piezoelektrischen Körper sind so gewählt, dass die als neutrale Achse bezeichnete neutrale Faserschicht außerhalb der Grenzfläche zwischen benachbarten Schichten zu liegen kommt. Für den Aufbau des Biegewandlerelementes wird hier ferner vorgeschlagen, dass bei nur einseitig vorhandenem piezoelektrischem Körper das Wärmeausdehnungsverhalten des Substrates genau mit demjenigen des piezoelektrischen Materiales übereinstimmen sollte.

Ein aus der DE 89 09 563 U1 bekannter piezoelektrischer Biegewandler besteht aus einer piezokeramischen Schicht, an der auf entgegengesetzten Seiten Elektroden unterschiedlicher Dicke angebracht sind. Die dickere Elektrode fungiert hierbei als Träger und bewirkt, dass die neutrale Schicht des piezoelektrischen Körpers aus dessen Symmetrieebene verschoben wird.

Der vorliegenden Erfindung liegt die Aufgabe zugrunde, einen Piezo-Biegewandler zu schaffen, dessen mindestens eines Biegeelement, trotz neutralem Verhalten unter Wärmeeinfluss, mit besonders hoher Effektivität betrieben werden kann.

Zur Lösung dieser Aufgabe ist vorgesehen, dass im Basiskörper, der in der Schichtungsrichtung einen heterogenen Aufbau mit mehreren sich in mindestens einer verformungsrelevanten Eigenschaft einschließlich Schichtdicke und/oder Elastizitätsmodul und/oder Wärmeausdehnungskoeffizient voneinander unterscheidenden Basiskörperschichten besitzt, diese Basiskörperschichten in ihren verformungsrelevanten Eigenschaften unter Berücksichtigung von Schichtdicke, Elastizitätsmodul und Wärmeausdehnungskoeffizient so aufeinander abgestimmt sind, dass aus dem gesamthaften Verformungsverhalten des Basiskörpers in Kombination mit dem Verformungsverhalten des piezoelektrischen Körpers ein zum piezoelektrischen Körper beabstandeter Verlauf der neutralen Faserschicht des Biegewandlerelementes innerhalb des Basiskörpers resultiert und zugleich die in der Schichtungsrichtung beidseits der neutralen Faserschicht liegenden Abschnitte des Biegewandlerelementes untereinander ein zumindest im Wesentlichen identisches thermisches Ausdehnungsverhalten aufweisen.

Auf diese Weise lässt sich ein Biegewandlerelement realisieren, dessen neutrale Faserschicht, also die Schicht, in der beim Biegevorgang weder Längsdehnungen noch Längsstauchungen auftreten, verhältnismäßig weit vom piezoelektrischen Körper entfernt verläuft. Dies führt im Betrieb zu einer gegenüber konventionellen Bauformen beträchtlichen Steigerung des erzielbaren Biegemomentes bei gleicher Betriebsspannung. Das Biegewandlerelement ist jedoch nicht nur hinsichtlich einer optimierten Effektivität ausgelegt, sondern zeichnet sich zugleich durch ein insgesamt neutrales thermisches Ausdehnungsverhalten aus, bedingt durch die untereinander im Wesentlichen identischen thermischen Ausdehnungsverhalten der beidseits der neutralen Faserschicht liegenden Dickenabschnitte des Biegewandlerelementes. Durch gegenseitige Abstimmung der einzelnen Parameter unter Einbeziehung von insbesondere Schichtdicke, Elastizitätsmodul und Wärmeausdehnungskoeffizient der verschiedenen Materialien liegt somit ein Biegewandlerelement vor, das thermisch stabil ist und zugleich ein sehr hohes Biegemoment erzeugen kann.

Vorteilhafte Weiterbildungen der Erfindung gehen aus den Unteransprüchen hervor.

Im einfachsten Fall kann der Basiskörper einen zweischichtigen Aufbau besitzen. Ohne weiteres können jedoch auch mehr als zwei Basiskörperschichten vorgesehen sein.

Der Basiskörper kann einen über die gesamte Dicke hinweg konstanten Umriss aufweisen, wobei er als Tragkörper fungiert, der auf der einen Seite mit dem piezoelektrischen Körper belegt ist und auf der entgegengesetzten Seite unbelegt ist.

Gleichfalls besteht aber auch die Möglichkeit, die Umrisse der einzelnen Basiskörperschichten zu variieren. Hier bietet es sich insbesondere an, einen als Träger für den einseitig angeordneten piezoelektrischen Körper fungierenden Tragkörper mit über die gesamte Dicke hinweg konstantem Umriss vorzusehen, der auf der dem piezoelektrischen Körper entgegengesetzten Seite mit einem als Zusatzkörper fungierenden weiteren Abschnitt belegt ist, dessen Umriss geringer ist als derjenige des Tragkörpers. Sowohl Tragkörper als auch Zusatzkörper können ein- oder mehrschichtig aufgebaut sein.

Für den Aufbau des piezoelektrischen Körpers bestehen prinzipiell keine Einschränkungen. Er kann einen monolithischen, sogenannten Single-Layer-Aufbau haben oder einen Multi-Layer-aufbau besitzen. Ein Vorteil der Erfindung besteht darin, dass man durch einen entsprechend konfigurierten Basiskörper in Kombination mit praktisch jedwedem piezoelektrischen Körper ein die erfindungsgemäß angestrebten Eigenschaften aufweisendes Biegewandlerelement realisieren kann.

Nachfolgend wird die Erfindung anhand der beiliegenden Zeichnung näher erläutert. In der Zeichnung zeigen:
- Figur 1: in schematischer Darstellung einen Längsschnitt durch eine mögliche erste Ausführungsform des erfindungsgemäßen Piezo-Biegewandlers, und
- Figur 2: ebenfalls eine schematische Längsschnittdarstellung einer weiteren Ausführungsform des Piezo-Biegewandlers.

Die beiden aus der Zeichnung ersichtlichen Piezo-Biegewandler 1 enthalten jeweils ein einziges, bevorzugt streifen- oder plattenförmiges Biegewandlerelement 2. Hiervon abweichend sind auch Bauformen möglich, bei denen mehrere Biegewandlerelemente 2 zu einer Piezo-Biegewandlereinheit 1 zusammengefasst sind, insbesondere in seitlicher Nebeneinanderanordnung.

Die Biegewandlerelemente 2 können beispielsweise als Stellglied in einem sogenannten Piezoventil eingesetzt werden. Dabei können sie ein Ventilglied betätigen oder unmittelbar selbst bilden. Die Einsatzmöglichkeiten sind jedoch völlig offen und auf dieses Ausführungsbeispiel nicht beschränkt.

Das Biegewandlerelement 2 hat bevorzugt längliche Gestalt und kann an seinem rückwärtigen Endbereich 3 ortsfest fixiert werden. Entsprechende Lagerungsmittel sind bei 4 schematisch angedeutet. Es kann sich beispielsweise um eine feste Einspannung in einem nicht weiters dargestellten Ventilgehäuse handeln.

In Abhängigkeit vom Anwendungsfall kann die Art der Aufhängung bzw. Lagerung des Biegewandlerelementes 2 variieren. So kann beispielsweise bei einem membranartig gestalteten Biegewandlerelement an mehreren über den Umfang verteilten Stellen eine Abstützung bzw. Fixierung vorgesehen werden.

Im Betrieb wird das Biegewandlerelement 2 mit einer Ansteuerspannung beaufschlagt. Eine entsprechende Ansteuerschaltung ist bei 5 schematisch angedeutet. Das Anlegen einer Ansteuerspannung bewirkt, dass das Biegewandlerelement 2 gemäß Pfeil 6 in einer zur Zeichenebene parallelen Auslenkebene seitwärts ausgelenkt wird. Beim Ausführungsbeispiel, das eine nur einseitige Einspannung des Biegewandlerelement 2 vorsieht, wird der größte Auslenkhub am vorderen Endbereich 7 des Biegewandlerelementes 2 zu messen sein. Im ausgelenkten Zustand besitzt das Biegewandlerelement 2 eine in der Auslenkebene gekrümmte Gestalt.

Das beispielhafte Biegewandlerelement 2 besitzt einen monomorphen Aufbau und ist derart ausgelegt, dass es ausgehend von seiner aus der Zeichnung ersichtlichen, im deaktivierten Zustand eingenommenen, im Wesentlichen geradlinigen Grundstellung durch Anlegen der Ansteuerspannung in einer Richtung gemäß Pfeil 6 auslenkbar ist. Wird die Ansteuerspannung entfernt und das Biegewandlerelement 2 entladen, kehrt es in die Grundstellung zurück.

Bei einem Einsatz in einem Ventil kann der Piezo-Biegewandler 1 wahlweise so eingesetzt werden, dass das Biegewandlerelement 2 im elektrisch deaktivierten Zustand entweder eine Schließstellung oder eine Offenstellung einnimmt, in der es einen Ventilkanal verschließt oder freigibt.

Das Biegewandlerelement 2 besitzt einen im Wesentlichen streifen- oder plattenförmig gestalteten Basiskörper 8 mit mehrschichtigem Aufbau. Die durch einen Doppelpfeil angedeutete Schichtungsrichtung 12 der diversen Basiskörperschichten 13 verläuft rechtwinkelig zur Hauptausdehnungsebene des Biegewandlerelementes 2 und mithin parallel zu dessen Auslenkebene.

An einer seiner beiden großflächigen Seiten, die im Folgenden - ohne dass damit eine Einschränkung verbunden sein soll - als Oberseite 14 bezeichnet wird, ist der Basiskörper 8 mit einem bevorzugt ebenfalls streifenförmigen piezoelektrischen Körper 15 belegt, wobei im Fügebereich eine feste Verbindung vorliegt.

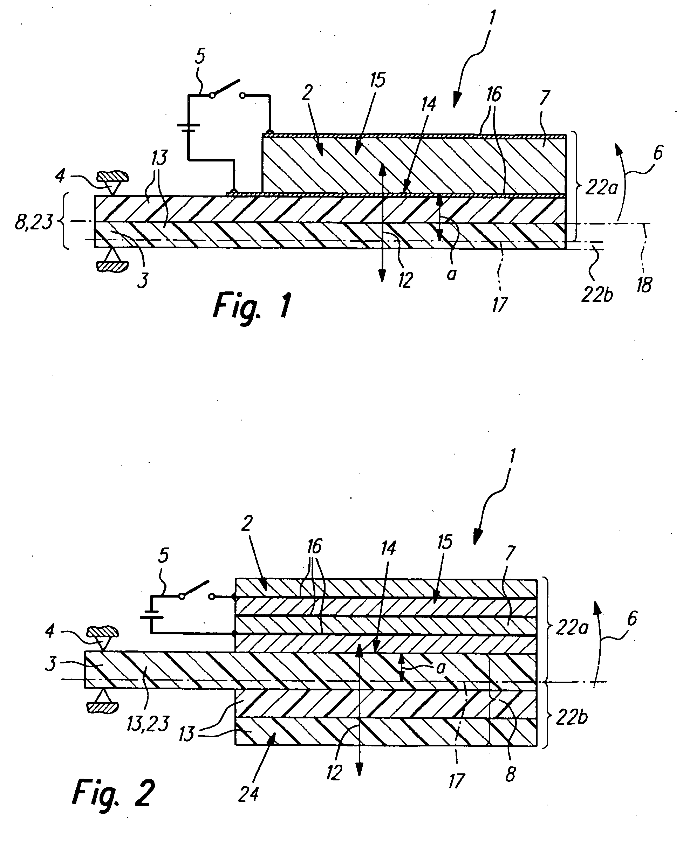

Beim Ausführungsbeispiel der Figur 1 besitzt der piezoelektrische Körper 15 einen monolithischen Aufbau. Im Gegensatz dazu verfügt er beim Ausführungsbeispiel der Figur 2 über eine Mehrschichtstruktur. In beiden Fällen setzt er sich aus einem piezoelektrisch aktivierbaren Material zusammen, beispielsweise einer Blei-Zirkonat-Titan-Oxidkeramik (PZT) oder einer anderen Piezokeramik.

Für die elektrische Aktivierung ist der piezoelektrische Körper 15 gemäß Figur 1 an der dem Basiskörper 8 zugewandten Unterseite sowie der entgegengesetzten Oberseite mit je einer Elektrodenschicht 16 versehen. Beim Ausführungsbeispiel der Figur 2 befinden sich Elektrodenschichten 16 zwischen den einzelnen Schichtelementen des piezoelektrischen Körpers 15 sowie im Bedarfsfalle vergleichbar der Figur 1 auch noch an der Ober- und Unterseite. Die Elektrodenschichten 16 sind in der erforderlichen Weise mit der Ansteuerschaltung 5 kontaktiert.

Die Elektrodenschichten 16 könnten beispielsweise durch Einbrennsilber oder durch Besputtern realisiert sein. Ein Aufbringen durch Siebdruck unter Verwendung eines Carbonlackes wird ebenfalls als vorteilhaft angesehen. Im Übrigen können die Elektrodenschichten auf jede beliebige Weise realisiert werden.

Der piezoelektrische Körper 15 verfügt über ein vorgegebenes thermisches Ausdehnungsverhalten und auch vorgegebene Verformungseigenschaften. Diese Parameter hängen insbesondere vom Material und von der in der Schichtungsrichtung 12 gemessenen Dicke des piezoelektrischen Körpers 15 ab. Diese Parameter können vom Hersteller des Piezo-Biegewandlers 1 kaum beeinflusst werden, so dass der Piezo-Biegewandler 1 auf der Basis der vorgegebenen Eigenschaften des piezoelektrischen Körpers 5 zu konzipieren ist.

In diesem Zusammenhang zeichnet sich das Biegewandlerelement 2 durch einen in der Schichtungsrichtung 12 heterogenen Aufbau aus. Dieser resultiert daraus, dass sich die verschiedenen Basiskörperschichten 13 des Basiskörpers 8 untereinander insbesondere in ihrer in der Schichtungsrichtung 12 gemessenen Schichtdicke und/oder in ihrem Elastizitätsmodul (E-Modul) und/oder in ihrem linearen Wärmeausdehnungskoeffizient (α) voneinander unterscheiden. Beim Ausführungsbeispiel der Figur 1 enthält der Basiskörper 8 insgesamt zwei derart unterschiedlich konzipierte Basiskörperschichten 13, während beim Ausführungsbeispiel der Figur 2 insgesamt drei unterschiedliche Basiskörperschichten 13 vorhanden sind.

Enthält der Basiskörper 8 mehr als zwei Basiskörperschichten 13, können mehrere dieser Schichten auch über übereinstimmende verformungsrelevante Eigenschaften verfügen. Auch können mehrere Schichtgruppen untereinander über die gleichen Eigenschaften verfügen. Jedenfalls sind jedoch mindestens zwei Basiskörperschichten 8 vorhanden, die sich in wenigstens einer und vorzugsweise in mehreren oder sämtlichen der vorgenannten verformungsrelevanten Eigenschaften voneinander unterschieden.

Die Auswahl der diversen Parameter erfolgt allerdings nicht willkürlich, sondern unter der Vorgabe des Erzielens eines gesamthaften Verformungsverhaltens des schichtförmigen Basiskörpers 8 dahingehend, dass sich in Kombination mit dem angesprochenen Verformungsverhalten des zugeordneten piezoelektrischen Körpers 15 ein zu dem piezoelektrischen Körper 15 beabstandeter Verlauf der neutralen Faserschicht 17 des Biegewandlerelementes 2 einstellt. Die neutrale Faserschicht 17 verläuft hierbei mit einem in der Schichtungsrichtung 12 gemessenen Abstand a zum Fügebereich zwischen dem piezoelektrischen Körper 15 und dem Basiskörper 8 innerhalb des Basiskörpers 8. Beim Ausführungsbeispiel der Figur 1 ist eine dahingehende Auslegung getroffen, dass die neutrale Faserschicht 17 auf der dem piezoelektrischen Körper 15 entgegengesetzten Seite der Mittelachse 18 des Basiskörpers 8 liegt. Dies ist jedoch nicht zwingend. Die Lage diesseits oder jenseits der Mittelachse 18 hängt vor allem auch von der Gesamtdicke des Basiskörpers 8 ab.

Als "neutrale Faserschicht 17" ist diejenige Schicht oder Achse innerhalb des Biegewandlerelementes 2 bezeichnet, in der unabhängig vom Auslenkungszustand des Biegewandlerelementes 2 keine Längsdehnungen oder Längsstauchungen auftreten. Wie sich gezeigt hat, lässt sich bei Aktivierung des Biegewandlerelementes 2 ein besonders hohes Biegemoment erzeugen, wenn die neutrale Faserschicht 17 möglichst weit vom piezoelektrischen Körper 15 entfernt liegt. Durch den erfindungsgemäßen Aufbau kann eine solche Position der neutralen Faserschicht 17 relativ einfach durch aufeinander abgestimmte Auslegung der verschiedenen Basiskörperschichten 13 unter Berücksichtigung der Verformungseigenschaften des Biegewandlerelementes 2 erzielt werden.

Zusätzlich zu seiner hohen Betriebseffektivität zeichnet sich das Biegewandlerelement 2 aber auch noch durch eine im Wesentlichen vollkommene thermische Neutralität aus. Schwankungen in der Umgebungstemperatur führen folglich zu keinen unerwünschten Verformungen in der Auslenkebene. Um dies zu gewährleisten, wird durch die geschilderte Parametrierung eine besondere Lage der neutralen Faserschicht 17 innerhalb des Basiskörpers 8 vorgegeben, die sich dadurch auszeichnet, dass die in der Schichtungsrichtung 12 beidseits der neutralen Faserschicht 17 liegenden Abschnitte 22a, 22b des Biegewandlerelementes 2 ein zumindest im Wesentlichen identisches thermisches Ausdehnungsverhalten aufweisen. In diesem Zusammenhang setzt sich bei beiden Ausführungsbeispielen der auf der dem piezoelektrischen Körper 15 entgegengesetzten Seite der neutralen Faserschicht 17 liegende, untere Abschnitt 22b des Biegewandlerelementes 2 ausschließlich aus Komponenten des Basiskörpers 2 zusammen, während zu dem entgegengesetzten oberen Abschnitt 22a des Biegewandlerelementes 2 neben Bestandteilen des Basiskörpers 8 auch der piezoelektrische Körper 15 gehört.

Um unterschiedliche Elastizitätsmodule und/oder Wärmeausdehnungskoeffizienten zu erhalten, greift man insbesondere auf Basiskörperschichten 13 unterschiedlicher Materialarten zurück. Zweckmäßigerweise werden Kunststoffmaterialen verwendet, die in voneinander abweichender Weise mit Faserverstärkungen versehen sein können. Hierbei können einzeln oder gemischt sowohl Kohlenstofffasern als auch Glasfasern oder Aramidfasern eingesetzt werden.

Bei dem Ausführungsbeispiel der Figur 1 besitzt der Basiskörper 8 einen über die gesamte in der Schichtungsrichtung 12 gemessene Dicke hinweg konstanten Umriss. Er fungiert praktisch als Tragkörper 23 für den einseitig daran angebrachten piezoelektrischen Körper 15. Der zum Fixieren des Biegewandlerelementes 2 herangezogene rückwärtige Endbereich 3 des Biegewandlerelementes 2 befindet sich hier an dem Tragkörper 23.

Der Umriss des Basiskörpers 8 hat in der Schichtungsrichtung 12 jedoch nicht zwingend konstant zu sein. So zeigt das Ausführungsbeispiel der Figur 2 einen in der Schichtungsrichtung 12 abgestuften Umrissverlauf des Basiskörpers 8. Unmittelbar anschließend an den piezoelektrischen Körper 15 definiert mindestens eine Basiskörperschicht 13 einen auch zur Aufhängung des Biegewandlerelementes 2 verwendeten Tragkörper 23, wobei sich daran, auf der dem piezoelektrischen Körper 15 entgegengesetzten Seite, ein einen geringeren Umriss als der Tragkörper 23 aufweisender Zusatzkörper 24 befindet, der sich aus einem oder mehreren Basiskörperschichten 13 eines reduzierten Grundrisses zusammensetzt. Der Umriss dieses Zusatzkörpers 24 kann insbesondere dem Umriss des gegenüberliegend platzierten piezoelektrischen Körpers 15 entsprechen.

Sowohl der Tragkörper 23 als auch der Zusatzkörper 24 können ein- oder mehrschichtig aufgebaut sein.

Unter Anwendung der den Aufbau des Piezo-Biegewandlers 1 definierenden geschilderten Grundsätze ist ein Herstellungsverfahren realisierbar, mit dem sich den unterschiedlichsten Anforderungen Rechnung tragende Piezo-Biegewandler realisieren lassen.

## Patentansprüche

1. Piezo-Biegewandler, mit mindestens einem streifen- oder plattenförmigen Biegewandlerelement (2), das einen einseitig mit einem piezoelektrischen Körper (15) belegten, piezoelektrisch inaktiven mehrschichtigen Basiskörper (8) aufweist, wobei der Basiskörper (8) in der Schichtungsrichtung (12) einen heterogenen Aufbau besitzt mit mehreren sich in mindestens einer verformungsrelevanten Eigenschaft einschließlich Schichtdicke und/oder Elastizitätsmodul und/oder Wärmeausdehnungskoeffizient voneinander unterscheidenden Basiskörperschichten (13), **dadurch gekennzeichnet daß** diese Basiskörperschichten (13) in ihren verformungsrelevanten Eigenschaften unter Berücksichtigung von Schichtdicke, Elastizitätsmodul und Wärmeausdehnungskoeffizient so aufeinander abgestimmt sind, dass aus dem gesamthaften Verformungsverhalten des Basiskörpers in Kombination mit dem Verformungsverhalten des piezoelektrischen Körpers (15) ein zum piezoelektrischen Körper (15) beabstandeter Verlauf der neutralen Faserschicht (17) des Biegewandlerelementes (2) innerhalb des Basiskörpers (8) resultiert und zugleich die in der Schichtungsrichtung (12) beidseits der neutralen Faserschicht (17) liegenden Abschnitte (22a, 22b) des Biegewandlerelementes (2) untereinander ein zumindest im Wesentlichen identisches thermisches Ausdehnungsverhalten aufweisen.

2. Piezo-Biegewandler nach Anspruch 1, **dadurch gekennzeichnet, dass** der Basiskörper (8) einen zweischichtigen Aufbau besitzt.

3. Piezo-Biegewandler nach Anspruch 1, **dadurch gekennzeichnet, dass** der Basiskörper (8) einen mindestens dreischichtigen Aufbau besitzt.

4. Piezo-Biegewandler nach einem der Ansprüche 1 bis 3, **dadurch gekennzeichnet, dass** der Basiskörper (8) einen über die gesamte Dicke hinweg einen konstanten Umriss aufweisenden, auf der dem piezoelektrischen Körper (15) entgegengesetzten Seite unbelegten Tragkörper (23) bildet.

5. Piezo-Biegewandler nach einem der Ansprüche 1 bis 3, **dadurch gekennzeichnet, dass** sich der Basiskörper (8) aus einem Tragkörper (23) und einem an der dem piezoelektrischen Körper (15) entgegengesetzten Seite an dem Tragkörper (23) angeordneten, einen geringeren Umriss als der Tragkörper (23) aufweisenden Zusatzkörper (24) zusammensetzt.

6. Piezo-Biegewandler nach Anspruch 5, **dadurch gekennzeichnet, dass** der Tragkörper (23) und/oder der Zusatzkörper (24) mehrschichtig aufgebaut sind bzw. ist.

7. Piezo-Biegewandler nach einem der Ansprüche 1 bis 6, **dadurch gekennzeichnet, dass** der piezoelektrische Körper (15) einen Single-Layer-Aufbau oder einen Multi-Layer-Aufbau besitzt.

8. Piezo-Biegewandler nach einem der Ansprüche 1 bis 7, **dadurch gekennzeichnet, dass** mehrere Basiskörperschichten (8) aus unterschiedlichen Materialien bestehen.

9. Piezo-Biegewandler nach einem der Ansprüche 1 bis 8, **dadurch gekennzeichnet, dass** die neutrale Faserschicht (17) auf der dem piezoelektrischen Körper (15) entgegengesetzten Seite der Mittelachse (18) des Basiskörpers (8) liegt.

## Claims

1. Piezoelectric bending transducer with at least one strip- or plate-shaped bending transducer element (2) comprising a piezoelectrically inactive, multi-layer base body (8), one side of which is occupied by a piezoelectric body (15), wherein the base body (8) has, in the layering direction, a heterogeneous structure with a plurality of base body layers (13) differing from one another in at least one property relevant to deformation, including layer thickness and/or modulus of elasticity and/or coefficient of thermal expansion, **characterised in that** these base body layers (13) are so matched to one another in their properties relevant to deformation, these being layer thickness, modulus of elasticity and coefficient of thermal expansion, that the overall deformation of the base body in combination with the deformation behaviour of the piezoelectric body (15) results in a course of the neutral fibre layer (17) of the bending transducer element (2) within the base body (8) which is distant from the piezoelectric body (15), while the sections (22a, 22b) of the bending transducer element (2) which are located on both sides of the neutral fibre layer (17) in the layering direction exhibit an at least substantially identical thermal expansion behaviour.

2. Piezoelectric bending transducer according to claim 1, **characterised in that** the base body (8) has a two-layer structure.

3. Piezoelectric bending transducer according to claim 1, **characterised in that** the base body (8) has an at least three-layer structure.

4. Piezoelectric bending transducer according to any of claims 1 to 3, **characterised in that** the base body (8) forms a supporting body (23) having a constant contour across its entire thickness and being unoccupied on the side opposite the piezoelectric body (15).

5. Piezoelectric bending transducer according to any of claims 1 to 3, **characterised in that** the base body (8) is made up of a supporting body (23) and an auxiliary body (24) located on the side of the supporting body (23) which is opposite the piezoelectric body (15) and having a smaller contour than the supporting body (23).

6. Piezoelectric bending transducer according to claim 5, **characterised in that** the supporting body (23) and/or the auxiliary body (24) have/has a multi-layer structure.

7. Piezoelectric bending transducer according to any of claims 1 to 6, **characterised in that** the piezoelectric body (15) has a single-layer structure or a multi-layer structure.

8. Piezoelectric bending transducer according to any of claims 1 to 7, **characterised in that** each of a plurality of base body layers (8) consists of a different material.

9. Piezoelectric bending transducer according to any of claims 1 to 8, **characterised in that** the neutral fibre layer (17) is located on the side of the central axis (18) of the base body (8) which is opposite the piezoelectric body (15).

## Revendications

1. Transducteur piézo-électrique à flexion, avec au moins un élément transducteur à flexion (2) en forme de bande ou de plaque, qui présente un corps de base (8) multicouches piézo-électriquement inactif et portant sur un face un corps piézo-électrique (15), dans lequel le corps de base (8) présente une constitution hétérogène dans la direction d'empilement (12), avec plusieurs couches de corps de base (13) différant les unes des autres par au moins une propriété relative à la déformation, incluant l'épaisseur de couche et/ou le module élastique et/ou le coefficient de dilatation thermique, **caractérisé en ce que** ces couches de corps de base (13) sont adaptées les unes aux autres au niveau de leurs propriétés relatives à la déformation, en tenant compte de l'épaisseur de couche, du module élastique et du coefficient de dilatation thermique, de telle manière qu'à partir du comportement global de déformation du corps de base, en combinaison avec le comportement de déformation du corps piézo-électrique (15), on obtient à l'intérieur du corps de base (8) un parcours de la couche de fibre neutre (17) de l'élément transducteur à flexion distant du corps piézo-électrique (15) et, en même temps, les sections (22a, 22b) de l'élément transducteur à flexion (2) situées de part et d'autre de la couche de fibre neutre (17) dans la direction d'empilement (12) présentent un comportement de dilatation thermique au moins pour l'essentiel identique entre elles.

2. Transducteur piézo-électrique à flexion selon la revendication 1, **caractérisé en ce que** le corps de base (8) possède une structure à deux couches.

3. Transducteur piézo-électrique à flexion selon la revendication 1, **caractérisé en ce que** le corps de base (8) présente une structure à au moins trois couches.

4. Transducteur piézo-électrique à flexion selon l'une des revendications 1 à 3, **caractérisé en ce que** le corps de base (8) forme un corps support (23) présentant un contour constant sur toute l'épaisseur et libre du côté opposé au corps piézo-électrique (15).

5. Transducteur piézo-électrique à flexion selon l'une des revendications 1 à 3, **caractérisé en ce que** le corps de base (8) se compose d'un corps support (23) et d'un corps additionnel (24) placé sur le côté du corps support (23) opposé au corps piézo-électrique (15) et présentant un contour plus petit que le corps support (23).

6. Transducteur piézo-électrique à flexion selon la revendication 5, **caractérisé en ce que** le corps support (23) et/ou le corps additionnel (24) sont resp. est à structure multicouche.

7. Transducteur piézo-électrique à flexion selon l'une des revendications 1 à 6, **caractérisé en ce que** le corps piézo-électrique (15) possède une structure monocouche ou une structure multicouche.

8. Transducteur piézo-électrique à flexion selon l'une des revendications 1 à 7, **caractérisé en ce que** plusieurs couches de corps de base (8) sont constituées de matériaux différents.

9. Transducteur piézo-électrique à flexion selon l'une des revendications 1 à 8, **caractérisé en ce que** la couche de fibre neutre (17) se trouve du côté de l'axe médian (18) du corps de base (8) opposé au corps piézo-électrique (15).
